# EUROPEAN PATENT APPLICATION

(11) **EP 4 832 054 A1**
(43) Date of publication of application: **28.10.2026**
(21) Application number: 24907395.8
(22) Date of filing: 17.12.2024
(51) Int. Cl.: H01L 21/60, C22C 5/04, C22C 9/00, C22C 19/03

(54) **BONDING WIRE**

(30) Priority: 19.12.2023 JP 2023214234
(71) Applicant: Nippon Micrometal Corporation, Iruma-shi Saitama 358-0032 (JP)
(72) Inventor: ETO, Motoki, Iruma-shi, Saitama 358-0032 (JP); ODA, Daizo, Iruma-shi, Saitama 358-0032 (JP); OISHI, Ryo, Iruma-shi, Saitama 358-0032 (JP)
(74) Representative: Vossius & Partner Patentanwälte Rechtsanwälte mbB
(86) International application number: PCT/JP2024/044531
(87) International publication number: WO 2025/135010

(57) **Abstract**

To provide a novel Cu bonding wire that achieves a favorable FAB shape, and achieves favorable high-temperature and high-humidity reliability of a 1st bonding part even in a case of performing post-curing associated with sealing at a low temperature and for a short time. The Cu bonding wire includes a core material of Cu or Cu alloy, and a coating layer having a total concentration of Pt and Ni of 90 atomic% or more formed on a surface of the core material. The bonding wire is characterized in that: in a concentration profile in a depth direction of the wire obtained by performing measurement using Auger electron spectroscopy (AES) so that the number of measurement points in the depth direction is 50 or more for the coating layer, a thickness of the coating layer is 10 nm or more and 130 nm or less, an average value X is 0.3 or more and 20.0 or less where X is defined as an average value of a ratio of an Ni concentration C_{Ni} (atomic%) to a Pt concentration C_{Pt} (atomic%), C_{Pt}/C_{Ni}, for all measurement points in the coating layer, and the total number of measurement points in the coating layer whose absolute deviation from the average value X is 0.3X or less is 50% or more relative to the total number of measurement points in the coating layer.

## Description

### TECHNICAL FIELD

The present invention relates to a bonding wire. Furthermore, the present invention relates to a semiconductor device including the bonding wire.

### BACKGROUND ART

In semiconductor devices, electrodes formed on a semiconductor chip are connected with a lead frame or electrodes on a substrate using a bonding wire. A bonding process of a bonding wire is carried out by performing 1st bonding of a wire part onto an electrode on the semiconductor chip; forming a loop; and finally performing 2nd bonding of a wire part onto the lead frame or an external electrode on the substrate. In the 1st bonding, a tip end of wire is heated and melted by arc heat input to form a free air ball (FAB: Free Air Ball; hereinafter also simply referred to as "ball" or "FAB") through surface tension, and then this ball part is compression-bonded (hereinafter referred to as "ball-bonded") onto the electrode on the semiconductor chip. In the 2nd bonding, the wire part is compression-bonded (hereinafter referred to as "wedge-bonded") onto the external electrode by applying ultrasonic waves and load to the wire part without forming the ball. After the bonding process, the semiconductor chip and the bonding wire are sealed by a sealing resin material to obtain the semiconductor device.

Conventionally, gold (Au) has been a main material of the bonding wire, but substitution to copper (Cu) has been progressing mainly for LSI applications (for example, Patent Literatures 1 to 3). Cu has the drawback of being more susceptible to oxidation than Au. As a method of preventing the surface oxidation of the Cu bonding wire, there has been proposed a structure in which a surface of a Cu core material is coated with a metal such as Pd (Patent Literature 4). There has been also proposed a Pd-coated Cu bonding wire which has an improved bond reliability of the 1st bonding part by coating a surface of a Cu core material with Pd and adding Pd and Pt into the Cu core material (Patent Literature 5).

### RELATED ART REFERENCE

### Patent Literature

| | |
|---|---|
| Patent Literature 1: | JP-A-S61-48543 |
| Patent Literature 2: | JP-T-2018-503743 |
| Patent Literature 3: | WO 2017/221770 |
| Patent Literature 4: | JP-A-2005-167020 |
| Patent Literature 5: | WO 2017/013796 |

### SUMMARY OF INVENTION

### PROBLEM TO BE SOLVED BY THE INVENTION

In recent years, bonding wires are required to exhibit favorable bond reliability under a high-temperature and high-humidity environment.

In a case in which the material of the bonding wire is changed from Au to Cu, deterioration of bond reliability of a 1st bonding part under a high-temperature and high-humidity environment (hereinafter, also referred to as "high-temperature and high-humidity reliability of the 1st bonding part") is likely to become a problem. This is because, although the 1st bonding is performed by compression-bonding a ball part formed at a tip end of the bonding wire to an Al electrode on a semiconductor chip in a bonding process of the bonding wire, in a case of using a bonding wire made of Cu as a material, an intermetallic compound of Cu and Al is formed at a bonding part, and this intermetallic compound is likely to be corroded under a high-temperature and high-humidity condition. Furthermore, the bonding wire made of Cu as a material provides a poor FAB shape and may consequently provide an inferior compression-bonding shape of the 1st bonding part and thus cannot be sufficiently applied for narrow-pitch bonding required for high-density packaging. Guidelines for addressing these problems have been proposed by addition of elements to a Cu wire and application of Pd coating to the Cu wire (for example, Patent Literatures 3 and 5).

Herein, as described above, in manufacturing the semiconductor device, after the bonding process of the bonding wire, the entirety including the semiconductor chip and the bonding wire is sealed by the sealing resin material. Examples of a sealing method include: a method in which a sealing resin material in a solid state is heated and melted, a melted resin is poured into a mold, and the melted resin is cured after pressure molding to perform sealing; and a method in which a sealing resin material in a liquid state is used to perform sealing by using a microsyringe or the like. After sealing, post-curing is performed in order to promote curing of the sealing resin material; however, in a case of using a sealing resin material in a liquid state, conditions for such post-curing tend to be set to a low temperature and a short time, as compared with a case of using a sealing resin material in a solid state. Even in a case of using a sealing resin material in a solid state, from a viewpoint of improving productivity, there is a tendency to set conditions for post-curing to a lower temperature and a shorter time.

It has been found that, when conditions for the above-described post-curing associated with sealing are a low temperature and a short time in a case of using a bonding wire made of Cu as a material, deterioration of high-temperature and high-humidity reliability of the 1st bonding part is difficult to be avoided even by addition of elements to the Cu wire, application of Pd coating to the Cu wire, or the like. At the time of 1st bonding, ultrasonic vibrations are applied in order to promote deformation of the ball part, and a large amount of distortion is thereby introduced into the bonding part. When post-curing is performed at a relatively high temperature and for a long time as in a case of using a sealing resin material in a solid state, distortion of the bonding part is released; however, when post-curing is performed at a low temperature and for a short time as in a case of using a sealing resin material in a liquid state, distortion remains in the bonding part. When a large amount of residual distortion is present, a corrosion reaction of an intermetallic compound of Cu and Al is likely to progress, and it is estimated that deterioration of high-temperature and high-humidity reliability of the 1st bonding part cannot be suppressed by methods such as addition of elements to the Cu wire and application of Pd coating to the Cu wire, which have been conventionally reported.

The present invention provides a novel Cu bonding wire that achieves a favorable FAB shape, and achieves favorable high-temperature and high-humidity reliability of the 1st bonding part even in a case of performing post-curing associated with sealing at a low temperature and for a short time.

### MEANS FOR SOLVING PROBLEM

As a result of earnest investigation as to the problem described above, the present inventors have found that the problem described above can be solved by the bonding wire having the configuration described below, and completed the present invention.

That is, the present invention includes the following content.
<1> A bonding wire comprising: a core material of Cu or Cu alloy; and a coating layer having a total concentration of Pt and Ni of 90 atomic% or more formed on a surface of the core material, wherein
   in a concentration profile in a depth direction of the wire obtained by performing measurement using Auger electron spectroscopy (AES) so that the number of measurement points in the depth direction is 50 or more for the coating layer,
   a thickness of the coating layer is 10 nm or more and 130 nm or less,
   an average value X is 0.3 or more and 20.0 or less where X is defined as an average value of a ratio of an Ni concentration C_{Ni} (atomic%) to a Pt concentration C_{Pt} an (atomic%), C_{Pt}/C_{Ni}, for all measurement points in the coating layer, and
   a total number of measurement points in the coating layer whose absolute deviation from the average value X is 0.3X or less is 50% or more relative to a total number of measurement points in the coating layer.
<2> The bonding wire according to <1>, wherein when linearly approximating C_{Pt} or C_{Ni} by the method of least squares for all measurement points in the coating layer, a difference between a maximum value and a minimum value of the obtained approximate straight line in a depth range of the coating layer is 20 atomic% or less.
<3> The bonding wire according to <1> or <2>, wherein the concentration profile in the depth direction of the wire is obtained by performing measurement using AES under the following <Condition> while digging down the wire from its surface in the depth direction by Ar sputtering:
   <Condition> a center of width of a measuring surface is aligned with a center of width of the wire, the width of the measuring surface is 5% or more and 15% or less of a diameter of the wire, and a length of the measuring surface is five times the width of the measuring surface.
<4> The bonding wire according to any one of <1> to <3>, wherein the bonding wire contains Au at a surface thereof.
<5> The bonding wire according to <4>, wherein a concentration of Au at the surface of the wire is 10 atomic% or more and 90 atomic% or less.
<6> The bonding wire according to <5>, wherein the concentration of Au at the surface of the wire is measured using AES under the following <Condition>:
   <Condition> a center of width of a measuring surface is aligned with a center of width of the wire, the width of the measuring surface is 5% or more and 15% or less of a diameter of the wire, and a length of the measuring surface is five times the width of the measuring surface.
<7> The bonding wire according to any one of <1> to <6>, wherein the bonding wire contains one or more elements selected from the group consisting of B, P and Mg (hereinafter referred to as a "first additive element"), and a total concentration of the first additive element is 1 ppm by mass or more and 100 ppm by mass or less relative to the entire wire.
<8> The bonding wire according to any one of <1> to <7>, wherein the bonding wire contains one or more elements selected from the group consisting of Se, Te, As and Sb (hereinafter referred to as a "second additive element"), and a total concentration of the second additive element is 1 ppm by mass or more and 100 ppm by mass or less relative to the entire wire.
<9> The bonding wire according to any one of <1> to <8>, wherein the bonding wire contains one or more elements selected from the group consisting of Ga and Ge (hereinafter referred to as a "third additive element"), and a total concentration of the third additive element is 0.011% by mass or more and 1.5% by mass or less relative to the entire wire.
<10> The bonding wire according to any one of <1> to <3> and <7> to <9>, wherein the bonding wire contains one or more elements selected from the group consisting of Ti, V, Cr, Mn, Fe, Co, Zn, Zr, Nb, Mo, Ru, Rh, Ag, In, Sn, Ta, W, Os, Ir, Pd, Au, and Bi (hereinafter referred to as a "fourth additive element"), and a total concentration of the fourth additive element is 5 ppm by mass or more and 450 ppm by mass or less relative to the entire wire.
<11> The bonding wire according to any one of <4> to <6>, wherein the bonding wire contains one or more elements selected from the group consisting of Ti, V, Cr, Mn, Fe, Co, Zn, Zr, Nb, Mo, Ru, Rh, Ag, In, Sn, Ta, W, Os, Ir, Pd, Au, and Bi (hereinafter referred to as a "fourth additive element"), and a total concentration of the fourth additive element (provided that a concentration of Au is a concentration in the core material portion) is 5 ppm by mass or more and 450 ppm by mass or less relative to the entire wire.

### EFFECT OF THE INVENTION

The present invention can provide a novel Cu bonding wire that achieves a favorable FAB shape, and achieves favorable high-temperature and high-humidity reliability of the 1st bonding part even in a case of performing post-curing associated with sealing at a low temperature and for a short time.

### BRIEF DESCRIPTION OF DRAWINGS

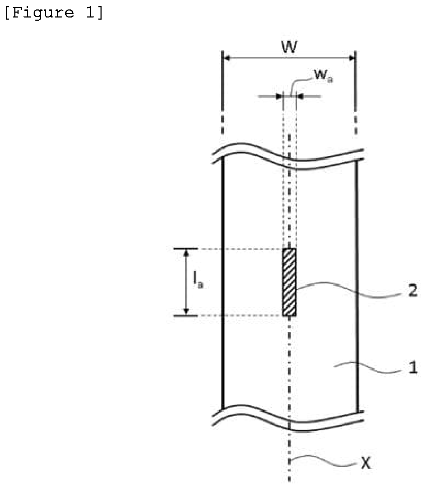

FIG. 1 is a schematic view illustrating a position and dimensions of a measuring surface for performing a composition analysis using AES.

### EMBODIMENT FOR CARRYING OUT THE INVENTION

Hereinafter, the present invention will be described in detail with reference to preferable embodiments thereof. Drawings may be referred to during the explanation. However, note that each drawing schematically shows the shape, size and arrangement of constituent elements only to the extent that the invention can be understood. The present invention is not limited to the following embodiments and examples and may be modified for implementation within the scope not departing from the scope of claims of the present invention and their equivalents.

### [Bonding wire]

A bonding wire according to the present invention (hereinafter also simply referred to as "wire of the present invention" or "wire") is characterized in that the bonding wire includes:
a core material of Cu or Cu alloy; and
a coating layer having a total concentration of Pt and Ni of 90 atomic% or more formed on a surface of the core material, wherein
in a concentration profile in a depth direction of the wire obtained by performing measurement using Auger electron spectroscopy (AES) so that the number of measurement points in the depth direction is 50 or more for the coating layer,
a thickness of the coating layer is 10 nm or more and 130 nm or less,
an average value X is 0.3 or more and 20.0 or less where X is defined as an average value of a ratio of an Ni concentration C_{Ni} (atomic%) to a Pt concentration C_{Pt} (atomic%), C_{Pt}/C_{Ni}, for all measurement points in the coating layer, and
a total number of measurement points in the coating layer whose absolute deviation from the average value X is 0.3X or less is 50% or more relative to a total number of measurement points in the coating layer.

As described above, in manufacturing a semiconductor device, after a bonding process of the bonding wire, the entirety including a semiconductor chip and the bonding wire is sealed by a sealing resin material. Examples of a sealing method include: a method in which a sealing resin material in a solid state is heated and melted, a melted resin is poured into a mold, and the melted resin is cured after pressure molding to perform sealing; and a method in which a sealing resin material in a liquid state is used to perform sealing by using a microsyringe or the like. After sealing, post-curing is performed in order to promote curing of the sealing resin material; however, in a case of using a sealing resin material in a liquid state, conditions for such post-curing tend to be set to a low temperature and a short time, as compared with a case of using a sealing resin material in a solid state (conditions for post-curing in a case of using a sealing resin material in a solid state are usually 170°C or higher and 4 hours or longer, whereas conditions for post-curing in a case of using a sealing resin material in a liquid state are usually 100 to 150°C and 3 hours or shorter). Even in a case of using a sealing resin material in a solid state, from a viewpoint of improving productivity, there is a tendency to set conditions for post-curing to a lower temperature and a shorter time.

In this regard, it has been found that, when conditions for post-curing associated with sealing are a low temperature and a short time in a case of using a bonding wire made of Cu as a material, deterioration of high-temperature and high-humidity reliability of the 1st bonding part is difficult to be avoided even by addition of elements to the Cu wire, application of Pd coating to the Cu wire, or the like. At the time of 1st bonding, ultrasonic vibrations are applied in order to promote deformation of the ball part, and a large amount of distortion is thereby introduced into the bonding part. When post-curing is performed at a relatively high temperature and for a long time as in a case of using a sealing resin material in a solid state, distortion of the bonding part is released; however, when post-curing is performed at a low temperature and for a short time as in a case of using a sealing resin material in a liquid state, distortion remains in the bonding part. When a large amount of residual distortion is present, a corrosion reaction of an intermetallic compound of Cu and Al is likely to progress, and it is estimated that deterioration of high-temperature and high-humidity reliability of the 1st bonding part cannot be suppressed by methods such as addition of elements to the Cu wire and application of Pd coating to the Cu wire, which have been conventionally reported. Furthermore, as described above, the bonding wire made of Cu as a material provides a poor FAB shape and may consequently provide an inferior compression-bonding shape of the 1st bonding part and thus cannot be sufficiently applied for narrow-pitch bonding required for high-density packaging.

In contrast, the present inventors have found that a favorable FAB shape can be achieved, and favorable high-temperature and high-humidity reliability of the 1st bonding part can be achieved even in a case of performing post-curing associated with sealing at a low temperature and for a short time, by using a bonding wire that includes: a core material of Cu or Cu alloy; and a coating layer having a total concentration of Pt and Ni of 90 atomic% or more formed on a surface of the core material, wherein in a concentration profile in the depth direction of the wire obtained by performing measurement using AES so that the number of measurement points in the depth direction is 50 or more for the coating layer, a thickness of the coating layer is 10 nm or more and 130 nm or less, an average value X is 0.3 or more and 20.0 or less where X is defined as an average value of a ratio of an Ni concentration C_{Ni} (atomic%) to a Pt concentration C_{Pt} (atomic%), C_{Pt}/C_{Ni}, for all measurement points in the coating layer, and a total number of measurement points in the coating layer whose absolute deviation from the average value X is 0.3X or less is 50% or more relative to a total number of measurement points in the coating layer.

A reason why the bonding wire of the present invention having the above-described configuration can provide favorable high-temperature and high-humidity reliability of the 1st bonding part even in a case in which post-curing associated with sealing is performed at a low temperature and for a short time, that is, even in a case in which residual distortion is present in the bonding part, is estimated as follows. When a ball is formed by using the bonding wire of the present invention, a concentrated layer in which concentrations of Pt and Ni are higher than those in an inner part is formed on an outer periphery of the ball, and Pt and Ni are concentrated at a bonding interface between the ball part of the wire and an Al electrode at the time of 1st bonding. When such a bonding part is exposed to a high-temperature and high-humidity environment, it is estimated that Ni forms a stable oxide film on a surface of the intermetallic compound of Cu and Al and can suppress progress of corrosion. Herein, it has been confirmed that, in providing favorable high-temperature and high-humidity reliability of the 1st bonding part, it is important that Pt is present together with Ni at a predetermined concentration. This is considered to be because Pt acts as a catalyst to promote formation of a stable oxide film by Ni.

Herein, even in a case in which Pt is present together with Ni at a predetermined concentration, the result may be a poor FAB shape, and consequently a compression-bonding shape of the 1st bonding part may be inferior; however, with the bonding wire of the present invention in which Pt is present together with Ni at a predetermined distribution, a favorable FAB shape can be provided, and thus a favorable compression-bonding shape of the 1st bonding part can also be provided, and it has also been found that it is possible to suitably cope with narrow-pitch bonding required for high-density packaging.

### <Core material of Cu or Cu alloy>

The wire of the present invention includes a core material of Cu or Cu alloy (hereinafter, also simply referred to as "Cu core material").

The Cu core material is not particularly limited as long as it is made of Cu or Cu alloy, and there may be used a known Cu core material constituting a conventional Pd-coated Cu wire which has been known as a bonding wire.

In the present invention, the concentration of Cu in the Cu core material may be, for example, 97 atomic% or more, 97.5 atomic% or more, 98 atomic% or more, 98.5 atomic% or more, 99 atomic% or more, 99.5 atomic% or more, 99.8 atomic% or more, 99.9 atomic% or more, 99.95 atomic% or more, or 99.99 atomic% or more in the center (axial core part) of the Cu core material.

The Cu core material may contain one or more dopants selected from a first additive element, a second additive element, a third additive element, and a fourth additive element described later, for example. Preferable contents of these dopants are described later.

In an embodiment, the Cu core material consists of Cu and inevitable impurities. In another embodiment, the Cu core material consists of Cu; one or more elements selected from the first additive element, the second additive element, the third additive element, and the fourth additive element described later; and inevitable impurities. The Cu core material may contain an element constituting the coating layer described later.

### <Coating layer>

The wire of the present invention includes a coating layer having a total concentration of Pt and Ni of 90 atomic% or more (hereinafter, also simply referred to as a "coating layer") formed on a surface of the Cu core material.

Even in a case of providing a favorable FAB shape and performing post-curing associated with sealing at a low temperature and for a short time, to achieve favorable high-temperature and high-humidity reliability of the 1st bonding part, it is important for the coating layer of the wire of the present invention to satisfy all of the following conditions (1) to (3) in a concentration profile in the depth direction of the wire obtained by performing measurement using AES so that the number of measurement points in the depth direction is 50 or more for the coating layer (hereinafter also simply referred to as "concentration profile in the depth direction of the wire").
(1) A thickness of the coating layer is 10 nm or more and 130 nm or less.
(2) An average value X is 0.3 or more and 20.0 or less where X is defined as an average value of a ratio of an Ni concentration C_{Ni} (atomic%) to a Pt concentration C_{Pt} (atomic%), C_{Pt}/C_{Ni}, for all measurement points in the coating layer.
(3) The total number of measurement points in the coating layer whose absolute deviation from the average value X is 0.3X or less is 50% or more relative to the total number of measurement points in the coating layer.

In the present invention, when obtaining the concentration profile in the depth direction of the wire by using AES, the measurement is performed so that the number of measurement points in the depth direction is 50 or more for the coating layer. In general, an analysis in the depth direction using AES can be performed at measurement intervals of sub-nano order, thus it is relatively easy to set the number of the measurement points to 50 or more in relation to the thickness of the coating layer of the present invention. If the number of the measurement points is less than 50 as a result of the measurement, the number of the measurement points is increased to 50 or more by lowering the sputtering rate, shortening the sputtering time, and the like, and then the measurement is performed again. This makes it possible to perform the measurement using AES so that the number of measurement points in the depth direction is 50 or more for the coating layer and obtain the concentration profile in the depth direction of the wire. Although it depends on the thickness of the coating layer, it is more preferable to determine the AES measurement point intervals such that the total number of measurement points in the coating layer becomes 70 (more preferably 100). Accordingly, in a preferable embodiment, the coating layer of the wire of the present invention satisfies all of the above-mentioned conditions (1) to (3) in the concentration profile in the depth direction of the wire obtained by performing the measurement using AES so that the number of measurement points in the depth direction is 50 or more for the coating layer.

### -Condition (1)-

The condition (1) relates to the thickness of the coating layer. By including the coating layer that satisfies the condition (1) in combination with the conditions (2) and (3), the wire of the present invention can achieve, even in a case of performing post-curing associated with sealing at a low temperature and for a short time, favorable high-temperature and high-humidity reliability of the 1st bonding part and can achieve a favorable FAB shape, and thus a favorable compression-bonding shape of the 1st bonding part.

Regarding the condition (1), the thickness of the coating layer (the calculation method based on the concentration profile in the depth direction of the wire will be described below) is, from the viewpoint of achieving favorable high-temperature and high-humidity reliability of the 1st bonding part, 10 nm or more, preferably 12 nm or more, 14 nm or more, 15 nm or more, 16 nm or more, 18 nm or more, or 20 nm or more, more preferably 25 nm or more, 30 nm or more, 40 nm or more, or 50 nm or more, further preferably 60 nm or more, 70 nm or more, 80 nm or more, or 90 nm or more. When the thickness of the coating layer is less than 10 nm, high-temperature and high-humidity reliability of the 1st bonding part tends to deteriorate in a case of performing post-curing associated with sealing at a low temperature and for a short time, and bond reliability of the 1st bonding part under a high-temperature environment (hereinafter, also referred to as "high-temperature reliability of the 1st bonding part") also tends to deteriorate. An upper limit of the thickness of the coating layer is, from the viewpoint of achieving favorable high-temperature and high-humidity reliability of the 1st bonding part and a favorable FAB shape, 130 nm or less, preferably 125 nm or less, 120 nm or less, 115 nm or less, or 110 nm or less. When the thickness of the coating layer is more than 130 nm, irregular shape and melting failure tend to occur during the FAB formation, which deteriorates the FAB shape and also the compression-bonding shape of the 1st bonding part.

### -Condition (2)-

The condition (2) relates to the average value X of the ratio of the Ni concentration C_{Ni} (atomic%) to the Pt concentration C_{Pt} (atomic%), C_{Pt}/C_{Ni}, for all measurement points in the coating layer described above. By including the coating layer that satisfies the condition (2) in addition to the conditions (1) and (3), the wire of the present invention can achieve, even in a case of performing post-curing associated with sealing at a low temperature and for a short time, favorable high-temperature and high-humidity reliability of the 1st bonding part.

Regarding the condition (2), the average value X is, from the viewpoint of achieving favorable high-temperature and high-humidity reliability of the 1st bonding part, 20.0 or less, preferably 18.0 or less, more preferably 16.0 or less, 15.0 or less, 14.0 or less, 12.0 or less, or 10.0 or less, and further preferably 8.0 or less, 6.0 or less, 5.0 or less, 4.0 or less, 3.0 or less, or less than 3.0. When the ratio C_{Pt}/C_{Ni} is larger than 20.0, high-temperature and high-humidity reliability of the 1st bonding part tends to deteriorate in a case of performing post-curing associated with sealing at a low temperature and for a short time. Furthermore, a lower limit of the average value X is, from the viewpoint of achieving favorable high-temperature and high-humidity reliability of the 1st bonding part, 0.3 or more, preferably 0.4 or more, 0.5 or more, 0.6 or more, 0.8 or more, 1.0 or more, or more than 1.0. When the average value X is less than 0.3, high-temperature and high-humidity reliability of the 1st bonding part tends to deteriorate in a case of performing post-curing associated with sealing at a low temperature and for a short time.

### -Condition (3)-

The condition (3) relates to the total number of measurement points in the coating layer whose absolute deviation from the average value X described above is 0.3X or less being 50% or more relative to the total number of measurement points in the coating layer. By including the coating layer that satisfies the condition (3) in combination with the conditions (1) and (2), the wire of the present invention can achieve, even in a case of performing post-curing associated with sealing at a low temperature and for a short time, favorable high-temperature and high-humidity reliability of the 1st bonding part and can achieve a favorable FAB shape, and thus a favorable compression-bonding shape of the 1st bonding part.

The condition (3), together with the condition (2), indicates that the coating layer contains a Pt-Ni alloy, which contains Pt and Ni at a predetermined ratio, in a high concentration while reducing variations in a Pt/Ni ratio in the thickness direction of the coating layer. From the viewpoint of achieving favorable high-temperature and high-humidity reliability of the 1st bonding part even in a case of performing post-curing associated with sealing at a low temperature and for a short time, and achieving a further favorable FAB shape, the total number of measurement points in the coating layer whose absolute deviation from the average value X falls within a predetermined range (the preferred range is as described above) is preferably 55% or more or 60% or more, more preferably 65% or more, 70% or more, or 75% or more, further preferably 80% or more relative to the total number of measurement points in the coating layer.

In the concentration profile in the depth direction of the wire, from the viewpoint of achieving favorable high-temperature and high-humidity reliability of the 1st bonding part and achieving a particularly favorable FAB shape, when linearly approximating the Pt concentration C_{Pt} (atomic%) or the Ni concentration C_{Ni} (atomic%) by the method of least squares for all measurement points in the coating layer, a difference between a maximum value and a minimum value of the obtained approximate straight line in a depth (thickness) range of the coating layer is preferably 20 atomic% or less, more preferably 18 atomic% or less, 16 atomic% or less, or 15 atomic% or less, and further preferably 14 atomic% or less, 12 atomic% or less, 10 atomic% or less, 8 atomic% or less, 6 atomic% or less, or 5 atomic% or less. Specifically, in a case where the average value X is less than 1, it is preferable that, when linearly approximating C_{Ni} (atomic%) by the method of least squares for all measurement points in the coating layer, the difference between the maximum value and the minimum value of the obtained approximate straight line in the depth range of the coating layer falls within the range described above. In a case where the average value X is 1 or more, it is preferable that, when linearly approximating C_{Pt} (atomic%) by the method of least squares for all measurement points in the coating layer, the difference between the maximum value and the minimum value of the obtained approximate straight line in the depth range of the coating layer falls within the range described above.

The thickness of the coating layer in the condition (1), the average value X and the absolute deviation from the average value X, the total number of the measurement points whose absolute deviation falls within the predetermined range, and the proportion of the total number of measurement points whose absolute deviation falls within the predetermined range relative to the total number of measurement points in the coating layer in the conditions (2) and (3) can be confirmed and determined by performing a composition analysis using AES while digging down the wire from its surface in the depth direction (direction to the center of the wire) by Ar sputtering. Specifically, a change in concentration of each element in the direction from the surface of the wire toward the depth (center) of the wire (so-called a concentration profile in the depth direction) is obtained by performing 1) a composition analysis of the wire surface, and then repeating 2) a sputtering process with Ar and 3) a surface composition analysis after the sputtering treatment, and the above factors can be confirmed and determined on the basis of the concentration profile. In the present invention, for obtaining the concentration profile in the depth direction, the unit of depth was in terms of SiO₂.

When performing 1) the composition analysis of the wire surface and 3) the surface composition analysis after the sputtering treatment, a position and dimensions of a measuring surface are determined as follows. In the following description, the width of the measuring surface indicates the dimension of the measuring surface in a direction perpendicular to a wire axis (a thickness direction of the wire), and the length of the measuring surface indicates the dimension of the measuring surface in a direction along the wire axis (a length direction of the wire). A further description will be provided with reference to FIG. 1. FIG. 1 is a schematic plan view illustrating a wire 1 in which the direction of the wire axis (the length direction of the wire) corresponds to the vertical direction (up-down direction) of FIG. 1 and the direction perpendicular to the wire axis (the thickness direction of the wire) corresponds to the horizontal direction (left-right direction) of FIG. 1. FIG. 1 shows a measuring surface 2 in relation to the wire 1. The width of the measuring surface 2 is represented by a dimension wₐ of the measuring surface in the direction perpendicular to the wire axis, and the length of measuring surface 2 is represented by a dimension lₐ of the measuring surface in the direction of the wire axis.

The measuring surface is determined so that a center of width of the measuring surface is aligned with a center of width of the wire in the direction perpendicular to the wire axis, and the width of the measuring surface is 5% or more and 15% or less of a diameter of the wire. The length of the measuring surface is set to be five times the width of the measuring surface. In FIG. 1, the width of the wire is indicated by a symbol W, and the center of the width of the wire is indicated by a dashed line X. Thus, the measuring surface 2 is determined so that the center of width of the measuring surface 2 is aligned with the dashed line X indicating the center of width of the wire, and the width wₐ of the measuring surface is 5% or more and 15% or less of the diameter of the wire (the same value as the width W of the wire), that is, 0.05W or more and 0.15W or less. Furthermore, the length lₐ of the measuring surface satisfies the relation of lₐ = 5wₐ. By determining the position and the dimensions of the measuring surface as described above, it is possible to accurately measure success or failure of the conditions (1) to (3), which are suitable for providing a favorable FAB shape, and achieving favorable high-temperature and high-humidity reliability of the 1st bonding part even in a case of performing post-curing associated with sealing at a low temperature and for a short time. Furthermore, it is preferable to perform the measurement for measuring surfaces at a plurality of points (n ≥ 3) which are separated from each other by 1 mm or more in the direction of the wire axis, and employ an arithmetic average value thereof.

The thickness of the coating layer in the above-mentioned condition (1), the average value X and the absolute deviation from the average value X, the total number of measurement points whose absolute deviation falls within the predetermined range, and the proportion of the total number of measurement points whose absolute deviation falls within the predetermined range relative to the total number of measurement points in the coating layer in the above-mentioned conditions (2) and (3) are based on results of measurement under the conditions described in [Thickness analysis of coating layer using Auger electron spectroscopy (AES)] described later.

There will be described a tendency of the concentration profile in the depth direction obtained for the wire of the present invention according to an embodiment. Up to a certain depth position from the surface of the wire, Pt and Ni tend to coexist at a certain ratio in a high concentration. That is, there is a region (coating layer) where the total concentration of Pt and Ni is 90 atomic% or more and, in such a region, there tends to be a certain number of measurement points whose absolute deviation from the average value X is 0.3X or less where X is defined as an average value of the ratio of the Ni concentration C_{Ni} (atomic%) to the Pt concentration C_{Pt} (atomic%), C_{Pt}/C_{Ni}, for all measurement points in the coating layer. Further proceeding in the depth direction, the concentration of Pt and Ni tends to be decreased and the concentration of Cu tends to be increased. By focusing on the Pt concentration C_{Pt} (atomic%) and the Ni concentration C_{Ni} (atomic%) in such a concentration profile in the depth direction, it is possible to obtain the thickness and the total number of measurement points of the coating layer based on the thickness and the total number of measurement points of the region where the total concentration of Pt and Ni is 90 atomic% or more. Furthermore, the average value X can be obtained by arithmetically averaging the ratio C_{Pt}/C_{Ni} for all measurement points in the coating layer, and the total number of measurement points whose absolute deviation from the average value X is 0.3X or less can be obtained by confirming the absolute deviation from the average value X for all measurement points in the coating layer. In a case where the wire contains Au at a surface thereof as described below, the concentration of Au tends to be decreased and the concentration of Pt and Ni tends to be increased from the surface of the wire to a very shallow position in the concentration profile in the depth direction. In such a case as well, by focusing on the Pt concentration C_{Pt} (atomic%) and the Ni concentration C_{Ni} (atomic%), the thickness and the total number of measurement points of the coating layer can be obtained from the thickness and the total number of measurement points of the region where the total concentration of Pt and Ni is 90 atomic% or more. The average value X can be obtained by arithmetically averaging the ratio C_{Pt}/C_{Ni} for all measurement points in the coating layer, and the total number of measurement points whose absolute deviation from the average value X is 0.3X or less can be obtained by confirming the absolute deviation from the average value X for all measurement points in the coating layer.

### -Other preferable conditions for coating layer-

In the wire of the present invention, it is more preferable that the coating layer satisfies, in addition to all of the conditions (1) to (3) described above, one or both of the following conditions (4) and (5) based on the concentration profile in the depth direction of the wire.
(4) When defining the average value of the Pt concentration C_{Pt} (atomic%) for all measurement points in the coating layer as X_{Pt}, the total number of measurement points in the coating layer whose absolute deviation from the average value X_{Pt} is 0.1X_{Pt} or less is 50% or more relative to the total number of measurement points in the coating layer.
(5) When defining the average value of the Ni concentration C_{Ni} (atomic%) for all measurement points in the coating layer as X_{Ni}, the total number of measurement points in the coating layer whose absolute deviation from the average value X_{Ni} is 0.1X_{Ni} or less is 50% or more relative to the total number of measurement points in the coating layer.

Note that, in the conditions (4) and (5), the coating layer, the thickness thereof, and the total number of measurement points in the coating layer are as described above in relation to the conditions (1) to (3). The wire of the present invention including the coating layer that satisfies one or both of the conditions (4) and (5) in addition to the conditions (1) to (3) can achieve particularly favorable high-temperature and high-humidity reliability of the 1st bonding part and achieve a particularly favorable FAB shape even in a case of performing post-curing associated with sealing at a low temperature and for a short time.

The coating layer may contain one or more dopants selected from the first additive element, the second additive element, the third additive element, and the fourth additive element described later, for example. Preferable contents of these dopants are described later.

The wire of the present invention may further contain Au at a surface thereof. By further containing Au, the bondability of the 2nd bonding part can be further improved.

From the viewpoint of further improving the bondability of the 2nd bonding part, the concentration of Au at the surface of the wire of the present invention is preferably 10 atomic% or more, more preferably 15 atomic% or more, further preferably 20 atomic% or more, 22 atomic% or more, 24 atomic% or more, 25 atomic% or more, 26 atomic% or more, 28 atomic% or more, or 30 atomic% or more. From the viewpoint of achieving a favorable FAB shape, and a favorable compression-bonding shape of the 1st bonding part, the upper limit of the concentration of Au at the surface of the wire of the present invention is preferably 90 atomic% or less, more preferably 85 atomic% or less, further preferably 80 atomic% or less, 78 atomic% or less, 76 atomic% or less, 75 atomic% or less, 74 atomic% or less, 72 atomic% or less, or 70 atomic% or less. Accordingly, in a preferable embodiment, the concentration of Au at the surface of the wire of the present invention is 10 atomic% or more and 90 atomic% or less.

In the present invention, the concentration of Au at the surface can be determined by performing the composition analysis of the wire surface as a measuring surface using an Auger electron spectroscopy (AES) method. Herein, when determining the concentration of Au at the surface, a gas component such as carbon (C), sulfur (S), oxygen (O) and nitrogen (N), a non-metal element, and the like are not considered.

The composition analysis of the wire surface can be performed under the same conditions as in 1) the composition analysis of the wire surface described in relation to the method of obtaining the concentration profile in the depth direction. Specifically, when performing the composition analysis of the wire surface using Auger electron spectroscopy (AES), the position and dimensions of the measuring surface are determined as follows.

The measuring surface is determined so that a center of width of the measuring surface is aligned with a center of width of the wire in the direction perpendicular to the wire axis, and the width of the measuring surface is 5% or more and 15% or less of a diameter of the wire. The length of the measuring surface is set to be five times the width of the measuring surface. By determining the position and dimensions of the measuring surface as described above, it is possible to measure the concentration of Au at the wire surface, which is required for further improving the bondability of the 2nd bonding part, with high accuracy. Furthermore, it is preferable to perform the measurement for measuring surfaces at a plurality of points (n ≥ 3) which are separated from each other by 1 mm or more in the direction of the wire axis, and employ an arithmetic average value thereof.

The concentration of Au at the surface described above is based on a result of measurement under the conditions described in [Composition analysis of wire surface using Auger electron spectroscopy (AES)] described later.

In a case where the wire contains Au at the surface of the wire, a position indicating the maximum concentration of Au in the concentration profile in the depth direction of the wire is closer to the surface of the wire than a position indicating the maximum concentration of Pt or a position indicating the maximum concentration of Ni.

In the wire of the present invention, a boundary between the Cu core material and the coating layer is determined based on the total concentration of Pt and Ni in the concentration profile in the depth direction of the wire described above. The position at which the total concentration of Pt and Ni is 90 atomic% is determined as the boundary, and then a region where the total concentration of Pt and Ni is less than 90 atomic% is determined to be the Cu core material and a region where the total concentration of Pt and Ni is 90 atomic% or more is determined to be the coating layer. In the present invention, the boundary between the Cu core material and the coating layer is not necessarily a crystal grain boundary. The thickness of the coating layer can be determined, by confirming the concentration profile from the wire surface toward the center of the wire, as a distance from a depth position Z1 where the total concentration of Pt and Ni reaches 90 atomic% for the first time to a depth position Z2 where the total concentration of Pt and Ni decreases below 90 atomic% for the first time (Z2>Z1).

The wire of the present invention is characterized by including the coating layer that satisfies the conditions (1) to (3) described above. The average value X and the absolute deviation from the average value X, the total number of measurement points whose absolute deviation falls within the predetermined range, and the proportion of the total number of measurement points whose absolute deviation falls within the predetermined range relative to the total number of measurement points in the coating layer for the conditions (2) and (3) are determined by focusing on the Pt concentration C_{Pt} (atomic%) and the Ni concentration C_{Ni} (atomic%) in the coating layer determined by the boundary determination method described above.

In an embodiment, the coating layer consists of Pt and Ni; and inevitable impurities. In another embodiment, the coating layer consists of Pt and Ni; one or more elements selected from Au, the first additive element, the second additive element, the third additive element, and the fourth additive element described later; and inevitable impurities. The coating layer may contain an element constituting the Cu core material described above.

The wire of the present invention may further contain one or more elements selected from the group consisting of B, P and Mg ("first additive element"). When the wire of the present invention contains the first additive element, the total concentration of the first additive element is preferably 1 ppm by mass or more relative to the entire wire. This makes it possible to provide a bonding wire that achieves a more favorable compression-bonding shape of the 1st bonding part. The total concentration of the first additive element relative to the entire wire is more preferably 2 ppm by mass or more, and further preferably 3 ppm by mass or more, 5 ppm by mass or more, 8 ppm by mass or more, 10 ppm by mass or more, 15 ppm by mass or more, or 20 ppm by mass or more. From the viewpoint of suppressing hardening of the wire and reducing chip damage at the time of 1st bonding, the total concentration of the first additive element is preferably 100 ppm by mass or less, and more preferably 90 ppm by mass or less, 80 ppm by mass or less, 70 ppm by mass or less, 60 ppm by mass or less or 50 ppm by mass or less. Accordingly, in a preferable embodiment, the wire of the present invention contains the first additive element, and the total concentration of the first additive element is 1 ppm by mass or more and 100 ppm by mass or less relative to the entire wire.

When the wire of the present invention contains the first additive element, the first additive element may be contained in either one of the Cu core material and the coating layer, or may be contained in both of them. When the wire of the present invention contains Au at a surface thereof, the first additive element may be contained together with Au. The first additive element is preferably contained in the Cu core material from the viewpoint of providing a bonding wire that achieves a further favorable compression-bonding shape of the 1st bonding part.

The wire of the present invention may further contain one or more elements selected from the group consisting of Se, Te, As and Sb ("second additive element"). When the wire of the present invention contains the second additive element, the total concentration of the second additive element is preferably 1 ppm by mass or more relative to the entire wire. This makes it possible to further improve the bond reliability of the 1st bonding part in a high-temperature and high-humidity environment. The total concentration of the second additive element relative to the entire wire is more preferably 2 ppm by mass or more, and further preferably 3 ppm by mass or more, 5 ppm by mass or more, 8 ppm by mass or more, 10 ppm by mass or more, 15 ppm by mass or more, or 20 ppm by mass or more. From the viewpoint of achieving a favorable FAB shape and a favorable compression-bonding shape of the 1st bonding part, the total concentration of the second additive element is preferably 100 ppm by mass or less, and further preferably 90 ppm by mass or less, 80 ppm by mass or less, 70 ppm by mass or less, 60 ppm by mass or less, or 50 ppm by mass or less. Accordingly, in a preferable embodiment, the wire of the present invention contains the second additive element, and the total concentration of the second additive element is 1 ppm by mass or more and 100 ppm by mass or less relative to the entire wire.

When the wire of the present invention contains the second additive element, the second additive element may be contained in either one of the Cu core material and the coating layer, or may be contained in both of them. From the viewpoint of providing a bonding wire that achieves a further favorable bond reliability of the 1st bonding part in a high-temperature and high-humidity environment, the second additive element is preferably contained in the coating layer. When the wire of the present invention contains Au at a surface thereof, the second additive element may be contained together with Au.

The wire of the present invention may further contain one or more elements selected from the group consisting of Ga and Ge ("third additive element"). When the wire of the present invention contains the third additive element, the total concentration of the third additive element is preferably 0.011% by mass or more relative to the entire wire. This makes it possible to improve the high-temperature reliability of the 1st bonding part. The total concentration of the third additive element relative to the entire wire is more preferably 0.015% by mass or more, and more preferably 0.02% by mass or more, 0.025% by mass or more, 0.03% by mass or more, 0.031% by mass or more, 0.035% by mass or more, 0.04% by mass or more, 0.05% by mass or more, 0.07% by mass or more, 0.09% by mass or more, 0.1% by mass or more, 0.12% by mass or more, 0.14% by mass or more, 0.15% by mass or more, or 0.2% by mass or more. From the viewpoint of achieving a favorable FAB shape, a favorable compression-bonding shape of the 1st bonding part, and a favorable bondability of the 2nd bonding part, the total concentration of the third additive element is preferably 1.5% by mass or less, and more preferably 1.4% by mass or less, 1.3% by mass or less or 1.2% by mass or less. Accordingly, in a preferable embodiment, the wire of the present invention contains the third additive element, and the total concentration of the third additive element is 0.011% by mass or more and 1.5% by mass or less relative to the entire wire.

When the wire of the present invention contains the third additive element, the third additive element may be contained in either one of the Cu core material and the coating layer, or may be contained in both of them. When the wire of the present invention contains Au at a surface thereof, the third additive element may be contained together with Au.

The wire of the present invention may further contain one or more elements selected from the group consisting of Ti, V, Cr, Mn, Fe, Co, Zn, Zr, Nb, Mo, Ru, Rh, Ag, In, Sn, Ta, W, Os, Ir, Pd, Au, and Bi (hereinafter, referred to as the "fourth additive element"). When the wire of the present invention contains the fourth additive element, the total concentration of the fourth additive element is preferably 5 ppm by mass or more relative to the entire wire. This makes it possible to suppress exfoliation of the coating layer, and suppress wire breakage at the time of wire-drawing processing. This is estimated to be because, by containing the fourth additive element at a predetermined concentration, after formation of the coating layer (Pt-Ni alloy layer), the fourth additive element diffuses and segregates at an interface between the coating layer and the Cu core material in stages of wire drawing and heat treatment, thereby improving adhesion between the coating layer and the Cu core material.

From the viewpoint of suppressing wire breakage at the time of wire-drawing processing, the total concentration of the fourth additive element relative to the entire wire is preferably 5 ppm by mass or more, more preferably 10 ppm by mass or more, 15 ppm by mass or more, 20 ppm by mass or more, or 25 ppm by mass or more, and further preferably 30 ppm by mass or more, 40 ppm by mass or more, 50 ppm by mass or more, 60 ppm by mass or more, 80 ppm by mass or more, or 100 ppm by mass or more.

From the viewpoint of suppressing wire breakage at the time of wire-drawing processing, the total concentration of the fourth additive element relative to the entire wire is preferably 450 ppm by mass or less, and may be 440 ppm by mass or less, 420 ppm by mass or less, or 400 ppm by mass or less, for example. Accordingly, in a preferable embodiment, the wire of the present invention contains the fourth additive element, and the total concentration of the fourth additive element is 5 ppm by mass or more and 450 ppm by mass or less relative to the entire wire. In a case of containing one or more elements selected from the group consisting of Ti, V, Cr, Mn, Fe, Co, and Zn (hereinafter, also referred to as a "fourth-a additive element") as the fourth additive element, an upper limit of total concentration of the fourth-a additive element may be 200 ppm by mass or less, 180 ppm by mass or less, 160 ppm by mass or less, or 150 ppm by mass or less, for example. In a case of containing one or more elements selected from the group consisting of Zr, Nb, Mo, Ru, Rh, Ag, In, and Sn (hereinafter, also referred to as a "fourth-b additive element") as the fourth additive element, an upper limit of total concentration of the fourth-b additive element may be 350 ppm by mass or less, 340 ppm by mass or less, 320 ppm by mass or less, or 300 ppm by mass or less, for example.

As described above, the wire of the present invention may contain Au at the surface thereof. When the wire of the present invention contains Au on the surface thereof, a concentration of Au as the fourth additive element is determined by using a concentration in a core material portion, which is obtained by exposing a cross section of the wire and measuring the Cu core material portion by an Electron Probe Micro Analyzer (EPMA) or Secondary Ion Mass Spectrometry (SIMS). That is, when the wire of the present invention further contains Au on the surface thereof, "the total concentration of the fourth additive element relative to the entire wire" is read as "the total concentration of the fourth additive element relative to the entire wire (provided that the concentration of Au is a concentration in the core material portion)" and is applied.

When the wire of the present invention contains the fourth additive element, the fourth additive element may be contained in either one of the Cu core material and the coating layer, or may be contained in both of them. From the viewpoint of further suppressing wire breakage at the time of wire-drawing processing, the fourth additive element is preferably contained in the Cu core material.

The contents of the first additive element, the second additive element, the third additive element, and the fourth additive element in the wire can be measured by the method described in [Measurement of element content] described later.

In the wire of the present invention, the total concentration of Cu, Ni, and Pt is, for example, 98.5% by mass or more, 98.6% by mass or more, 98.7% by mass or more, or 98.8% by mass or more, for example.

The diameter of the wire of the present invention is not particularly limited and may be appropriately determined according to a specific purpose. Preferably, the diameter of the wire may be 15 µm or more, 18 µm or more, or 20 µm or more, for example. The upper limit of the diameter is not particularly limited and may be 80 µm or less, 70 µm or less, or 50 µm or less, for example.

The wire of the present invention can achieve, even in a case of performing post-curing associated with sealing at a low temperature and for a short time, favorable high-temperature and high-humidity reliability of the 1st bonding part and can achieve a favorable FAB shape, and thus a favorable compression-bonding shape of the 1st bonding part. Accordingly, the bonding wire of the present invention can be preferably used for manufacturing a semiconductor device by connecting an electrode on the semiconductor chip to an external terminal such as a lead frame or an electrode on a substrate.

### <Manufacturing method of wire>

There will be described an example of a method for manufacturing the bonding wire according to the present invention.

First, raw material copper of high purity (4N to 6N; 99.99 to 99.9999% by mass or more) is processed into a large diameter (diameter of about 3 to 6 mm) by continuous casting to obtain an ingot.

In a case of adding a dopant such as the first additive element, the second additive element, the third additive element, and the fourth additive element described above, examples of an addition method therefor may include a method of causing the dopant to be contained in the Cu core material, a method of causing the dopant to be contained in the coating layer, a method of depositing the dopant on the surface of the Cu core material, and a method of depositing the dopant on the surface of the coating layer. These methods may be combined with each other. The effect of the present invention can be achieved by employing any addition method. In the method of causing the dopant to be contained in the Cu core material, a copper alloy containing a required concentration of dopant may be used as a raw material to manufacture the Cu core material. In a case of obtaining such a copper alloy by adding the dopant to Cu as the raw material, a dopant component having high purity may be directly added to Cu, or alternatively, a mother alloy containing a dopant component at a concentration of about 1% may be used. In the method of causing the dopant to be contained in the coating layer, the dopant may be contained in Pt, Ni plating bath at the time of forming the coating layer (in a case of wet plating), or in a target material (in a case of dry plating). In the method of depositing the dopant on the surface of the Cu core material and the method of depositing the dopant on the surface of the coating layer, at least one type of deposition treatment selected from (1) application of aqueous solution ⇒ drying ⇒ heat treatment, (2) a plating method (wet), and (3) a vapor deposition method (dry) may be performed on the surface of the Cu core material or the surface of the coating layer being as a deposition surface.

The ingot having a large diameter is subjected to forging, rolling, and wire-drawing to manufacture a wire made of Cu or a Cu alloy with a diameter of about 0.7 to 2.0 mm (hereinafter also referred to as an "intermediate wire").

As a method for forming the coating layer on the surface of the Cu core material, an electroplating, an electroless plating, a vapor deposition, and the like can be used. Among them, the electroplating is preferable industrially because it can stably control film thickness. For example, the coating layer may be formed on the surface of the intermediate wire. The coating layer may be deposited at a stage of the ingot having a large diameter, or the coating layer may be formed on the surface of the Cu core material after further thinning the intermediate wire by performing the wire-drawing (for example, after carrying out the wire-drawing to a final diameter of the Cu core material). The coating layer may be formed by, for example, providing a Pt-Ni alloy layer containing Pt and Ni at a predetermined ratio on the surface of the Cu core material. Alternatively, from the viewpoint of forming the coating layer with an excellent adhesiveness to the Cu core material, the coating layer may be formed by performing a strike plating with conductive metal on the surface of the Cu core material and then providing the Pt-Ni alloy layer containing Pt and Ni at the predetermined ratio thereon. Furthermore, after forming the Pt-Ni alloy layer containing Pt and Ni at the predetermined ratio, a layer containing at least one of Pt and Ni (for example, a Pt layer, an Ni layer, or a Pt-Ni alloy layer) may be further provided.

In a case of forming the wire containing Au at the surface thereof, the wire can be formed by providing an Au layer on the surface of the coating layer by the same method as described above.

The wire-drawing processing can be performed by using a continuous wire-drawing machine in which a plurality of diamond-coated dies can be set. If necessary, heat treatment may be performed during the wire-drawing processing. In the case of forming the wire containing Au at the surface thereof, the constituent elements are diffused to each other between the Au layer at the surface of the wire and the lower Pt-Ni alloy layer (the Pt layer, the Ni layer, or the Pt-Ni alloy layer, if provided) by the heat treatment, which makes it possible to form a region containing Au (for example, an alloy region containing Au, Pt, and Ni) at the surface of the wire so that the concentration of Au at the surface of the wire falls within the preferable range described above. As a method therefor, a method that promotes alloying by continuously sweeping the wire at a constant speed in an electric furnace at a constant furnace temperature is preferable in that the composition and thickness of the alloy can surely be controlled. In substitution for the method of forming the region containing Au by providing the Au layer on the surface of the coating layer and then performing the heat treatment, a method of depositing an alloy region originally containing Au and at least one of Pt and Ni may be employed.

### [Method for manufacturing semiconductor device]

The semiconductor device can be manufactured by connecting the electrode on the semiconductor chip to the lead frame or the electrode on the circuit board by using the bonding wire of the present invention.

In an embodiment, the semiconductor device according to the present invention includes a circuit board, a semiconductor chip, and a bonding wire for electrically connecting the circuit board and the semiconductor chip with each other, and is characterized in that the bonding wire is the wire of the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in JP 2020-150116 A, the semiconductor device may include a lead frame and a semiconductor chip mounted on the lead frame.

Examples of the semiconductor device may include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like.

### [Examples]

Hereinafter, the present invention will be described in detail with reference to Examples. However, the present invention is not limited to the following Examples.

### (Sample)

First, a method of preparing a sample will be described. For Cu as a raw material of the Cu core material, Cu having a purity of 99.99% by mass or more (4N) with the balance composed of inevitable impurities was used. In a case of adding the first additive element, the second additive element, the third additive element, and the fourth additive element, these additive elements having a purity of 99% by mass or more with the balance composed of inevitable impurities were used, or alternatively a mother alloy of Cu with a high concentration of these additive elements was used.

For the Cu alloy as the core material, the raw material was first charged into a graphite crucible and melted by heating to 1090 to 1500°C in an inert atmosphere such as an N₂ gas or Ar gas using a high-frequency furnace. Then, an ingot with a diameter of 3 to 6 mm was manufactured by continuous casting. Next, the ingot thus obtained was drawn to manufacture an intermediate wire with a diameter of 0.7 to 2.0 mm, and then, wire-drawing processing and the like were continuously performed thereon using dies to further reduce the diameter of the wire to be coated. In the wire-drawing processing, a commercially available lubricant was used, and the wire-drawing speed was set to 20 to 150 m/min. For forming the coating layer, an acid washing with hydrochloric acid or sulfuric acid was performed to remove an oxide film on the wire surface, and then a Pt-Ni alloy layer containing Pt and Ni at a predetermined ratio was formed so as to cover the entire surface of the Cu alloy as the core material. Furthermore, in some wires (Example Nos. 3, 7, 8, 15, 16, 47, and 48), an Au layer was provided on the Pt-Ni alloy layer. An electroplating method was used for forming the Pt-Ni alloy layer and the Au layer. As a Pt-Ni plating liquid and an Au plating liquid, commercially available plating liquids were prepared and used after appropriately adjusted.

Thereafter, the wire was further subjected to wire-drawing processing and the like to be processed to have a final wire diameter of φ18 µm. During the wire-drawing processing, intermediate heat treatment was performed 1 to 2 times at 300 to 700°C for 2 to 15 seconds as needed. The intermediate heat treatment was performed while continuously sweeping the wire under flowing of an N₂ gas or Ar gas. After the wire was processed to have the final wire diameter, a refining heat treatment was performed while continuously sweeping the wire under flowing of an N₂ gas or Ar gas. The heat treatment temperature for the refining heat treatment was 200 to 600°C, the wire feeding speed was 20 to 200 m/min, and the heat treatment time was 0.2 to 1.0 seconds. If the coating layer was thin, the heat treatment temperature was set to be lower and the wire feeding speed was set to be higher. If the coating layer was thick, the heat treatment temperature was set to be higher and the wire feeding speed was set to be lower.

### (Test and evaluation methods)

There will be described test and evaluation methods.

### [Composition analysis of wire surface using Auger electron spectroscopy (AES)]

Regarding the wire containing Au at the surface of the wire, the concentration of Au at the surface of the wire was determined by performing a measurement using the Auger electron spectroscopy (AES) where the measuring surface was a surface of the wire as follows.

First, the bonding wire to be measured was fixed to a sample holder in a linear arrangement. Next, the measuring surface was determined so that the center of width of the measuring surface was aligned with the center of width of the wire in the direction perpendicular to the wire axis, and the width of the measuring surface was 5% or more and 15% or less of the diameter of the wire. The length of the measuring surface was set to be five times the width of the measuring surface. With using an AES apparatus (PHI-700 manufactured by ULVAC-PHI, INC.), the composition analysis was performed on the surface of the wire under a condition of acceleration voltage of 10 kV to obtain a surface Au concentration (atomic%).

The composition analysis using the AES was performed on the measuring surfaces at three points which were separated from each other by 1 mm or more in the direction of the wire axis, and an arithmetic average value thereof was employed. When determining the concentration of Au at the surface, a gas component such as carbon (C), sulfur (S), oxygen (O), or nitrogen (N), a nonmetallic element, and the like were not considered.

### [Thickness analysis of coating layer using Auger electron spectroscopy (AES)]

A depth analysis using AES was used for the thickness analysis of the coating layer. The depth analysis using AES analyzes a change in a composition in the depth direction by alternately performing a composition analysis and sputtering, so that a change in concentration of each element in the direction from the surface of the wire toward the depth (center) of the wire (so-called a concentration profile in the depth direction) can be obtained.

Specifically, the concentration profile in the depth direction was obtained with AES by performing 1) a composition analysis of the wire surface, and then repeating 2) a sputtering process with Ar and 3) a surface composition analysis after the sputtering treatment. The sputtering treatment in 2) was performed at an acceleration voltage of 2 kV with Ar⁺ ion. In the surface composition analysis in 1) and 3), the dimensions of the measuring surface and the conditions for the composition analysis by the AES were the same as those described in [Composition analysis of wire surface using Auger electron spectroscopy (AES)] described above. For obtaining the concentration profile in the depth direction using AES, the measurement was performed so that the number of measurement points in the depth direction is 50 or more for the coating layer.

The concentration profile in the depth direction was obtained for the measuring surfaces at three points which were separated from each other by 1 mm or more in the direction of the wire axis.

### -Thickness of coating layer and total number of measurement points in coating layer-

In the obtained concentration profile in the depth direction, the concentration profile was confirmed from the wire surface toward the center of the wire to obtain a distance from the depth position Z1 where the total of the Pt concentration C_{Pt} (atomic%) and the Ni concentration C_{Ni} (atomic%) reached 90 atomic% for the first time to the depth position Z2 where the total of C_{Pt} and C_{Ni} decreased below 90 atomic% for the first time (Z2>Z1) as a measured thickness of the coating layer. Furthermore, the total number of measurement points from the depth position Z1 to the depth position Z2 was obtained as the total number of measurement points in the coating layer. The arithmetic average value of numerical values obtained for the measuring surfaces at three points was employed as the thickness of the coating layer. It was confirmed that the total number of measurement points in the coating layer was 50 to 100 for the wires of the Examples.

Note that the depth measured by the AES analysis is obtained as the product of the sputtering rate and time. Since the sputtering rate is generally measured using a reference sample SiO₂, the depth analyzed using AES is represented by an SiO₂ equivalent value. Thus, the unit for the thickness of the coating layer was in terms of SiO₂.

### -Average value X and total number of measurement points whose absolute deviation from average value X falls within predetermined range-

In the obtained concentration profile in the depth direction, the ratio of the Ni concentration C_{Ni} (atomic%) to the Pt concentration C_{Pt} (atomic%), C_{Pt}/C_{Ni}, for all measurement points in the coating layer was arithmetically averaged to obtain the average value X. Next, the absolute deviation from the average value X was calculated in the ratio C_{Pt}/C_{Ni} for all measurement points in the coating layer, and the total number of measurement points whose absolute deviation from the average value X is 0.3X or less was obtained. The arithmetic average value of numerical values obtained for the measuring surfaces at three points was employed as the average value X.

### -Slope of approximate straight line of C_{Pt} or C_{Ni} (difference between maximum value and minimum value in depth range of coating layer)-

C_{Pt} (atomic%) or C_{Ni} (atomic%) was linearly approximated by the method of least squares for all measurement points in the coating layer to obtain a difference (atomic%) between the maximum value and minimum value of the obtained approximate straight line in the depth range of the coating layer. Herein, if the average value X was less than 1, C_{Ni} (atomic%) was linearly approximated by the method of least squares for all measurement points in the coating layer, and if the average value X was 1 or more, C_{Pt} (atomic%) was linearly approximated by the method of least squares for all measurement points in the coating layer. As the difference (atomic%) between the maximum value and the minimum value of the obtained approximate straight line in the depth range of the coating layer, the arithmetic average value of numerical values obtained for the measuring surfaces at three points was employed.

### [Measurement of element content]

The contents of the first additive element, the second additive element, the third additive element, and the fourth additive element in the wire were detected as the concentration of elements contained in the entire wire by analyzing a liquid in which the bonding wire was dissolved with a strong acid using an ICP emission spectrometer or an ICP mass spectrometer. As an analysis apparatus, ICP-OES ("PS3520UVDDII" manufactured by Hitachi High-Tech Corporation) or ICP-MS ("Agilent 7700x ICP-MS" manufactured by Agilent Technologies, Inc.) was used. Regarding the wire further containing Au on the surface thereof, the concentration of Au as the fourth additive element was obtained by exposing a cross section of the wire and measuring the Cu core material portion by EPMA or SIMS.

### [FAB shape]

The evaluation of the FAB shape was performed by forming an FAB on a lead frame using a commercially available wire bonder and observing the FAB with a scanning electron microscope (SEM) (evaluation number N=100). The FAB was formed with a current value of 30 to 75 mA, an EFO gap of 762 µm, and a tail length of 254 µm while flowing an N₂ + 5% H₂ gas at a flow rate of 0.4 to 0.6 L/min. The diameter of the FAB was in the range of 1.5 to 1.9 times the wire diameter. The FAB shape was determined to be favorable if it had a true spherical shape and determined to be failure if it showed eccentricity, irregular shape, or poor melting. Evaluation was then performed in accordance with the following criteria.

### Evaluation criteria:

⊚: 5 or less failures
∘: 6 to 10 failures (no problem for practical use)
×: 11 or more failures

### [High-temperature and high-humidity reliability of 1st bonding part]

The high-temperature and high-humidity reliability of the 1st bonding part was evaluated by the Highly Accelerated Temperature and Humidity Stress Test (HAST).

Specifically, a sample was prepared by performing ball bonding, using a commercially available wire bonder, on an electrode that was disposed by depositing an Al-1.0 mass% Si-0.5 mass% Cu alloy having a thickness of 1.5 µm on a silicon substrate on a general metal frame. The resultant sample was sealed by a commercially available sealing resin material in a liquid state, and subjected to post-curing under conditions of 100°C for 1 hour and then 150°C for 3 hours to manufacture a sample for testing reliability of the 1st bonding part. The ball was formed under the conditions described in the section [FAB shape] noted above. The manufactured sample for testing the reliability of the 1st bonding part was exposed to a high-temperature and high-humidity environment with a temperature of 130°C and a relative humidity of 85% using an unsaturated type pressure cooker tester and was biased with 3 V. The shear test on the ball bonded part was performed every 48 hours, and a time until a value of shear force became half of the initial shear force was determined to be the bonding life of the 1st bonding part. An arithmetic average value of measurement values of 50 ball bonded parts randomly selected was used for the value of the shear force. The shear test was performed after removing the resin by acid treatment, and exposing the ball bonded part. Evaluation was then performed in accordance with the following criteria.

### Evaluation criteria:

⊚: Bonding life of 192 hours or more
∘: Bonding life of 96 hours or more and less than 192 hours
×: Bonding life of less than 96 hours

### [Compression-bonding shape]

The evaluation of the compression-bonding shape of the 1st bonding part (the crushed shape of ball) was carried out by forming a ball using a commercially available wire bonder under the conditions described in the section [FAB shape] noted above, compression-bonding the ball onto an electrode that had been formed by depositing an Al-1.0 mass% Si-0.5 mass% Cu alloy film having a thickness of 1.5 µm on a Si substrate, and observing the bonded part from directly above by an optical microscope (the number of evaluations N = 100). In the evaluation of the crushed shape of the ball, a case in which a crushed shape was close to true circle was determined to be favorable, and a case in which a crushed shape was an oval shape or a petal shape was determined to be failure. Evaluation was then performed in accordance with the following criteria.

### Evaluation criteria:

⊚: 1 or less failures
∘: 2 to 5 failures (no problem for practical use)
×: 6 or more failures

### [Bondability of 2nd bonding part]

The bondability of the 2nd bonding part was evaluated by a 2nd bonding window test. The 2nd bonding window test is a test for determining the number of conditions with which the bonding is made possible among a total of 36 conditions for 2nd bonding. Specifically, the test is conducted under a total of 36 conditions that indicates 6 stages of ultrasonic current at the time of 2nd bonding from 40 mA to 90 mA in 10 mA increments in the horizontal axis, and 6 stages of load at the time of 2nd bonding from 30 gf to 80 gf in 10 gf increments in the vertical axis.

### [Table 1]

**(Table 1)**

| | | Ultrasonic current (mA) | | | | | |
|---|---|---|---|---|---|---|---|
| | | 40 | 50 | 60 | 70 | 80 | 90 |
| | 30 | | | | | | |
| | 40 | | | | | | |
| Load (gf) | 50 | | | | | | |
| | 60 | | | | | | |
| | 70 | | | | | | |
| | 80 | | | | | | |

This test was performed on each wire of Examples and Comparative Examples. Specifically, by using a commercially available wire bonder, 200 wires were bonded to leads of a lead frame for each condition. An Ag-plated lead frame was used as the lead frame, and bonding was performed at a stage temperature of 200°C under a flow of an N₂+5% H₂ gas at a flow rate of 0.5 L/min. The number of conditions with which continuous bonding was able to be performed without causing problems such as non-bonding or stop of the bonder was determined, and evaluated in accordance with the following criteria.

### Evaluation criteria:

⊚: 33 conditions or more
∘: 25 to 32 conditions
×: 24 conditions or less

### [Wire-drawing processability]

Wire-drawing processing was performed to obtain the final wire diameter of 18 µm, and the number of times of wire breakage was checked. The feeding speed, the area reduction ratio, and the like as processing conditions for wire drawing were as described above, and a length of the drawn wire was 500,000 m. Evaluation was then performed in accordance with the following criteria.

### Evaluation criteria:

⊚: 1 time or less
∘: 2 times
×: 3 times or more

### [High-temperature reliability of 1st bonding part]

The high-temperature reliability of the 1st bonding part was evaluated by a High Temperature Storage Life Test (HTSL).

Specifically, a sample for testing the reliability of the 1st bonding part manufactured by the same procedure as that in the section of [High-temperature and high-humidity reliability of 1st bonding part] was exposed to an environment with a temperature of 150°C using a high-temperature thermostatic apparatus. The shear test on the ball bonded part was performed every 250 hours, and a time until a value of shear force became half of the initial shear force was determined to be the bonding life of the 1st bonding part. An arithmetic average value of measurement values of 50 ball bonded parts randomly selected was used for the value of the shear force. The shear test after the High Temperature Storage Life Test was performed after removing the resin by acid treatment, and exposing the ball bonded part. Evaluation was then performed in accordance with the following criteria.

### Evaluation criteria:

⊚: Bonding life of 1000 hours or more
∘: Bonding life of 500 hours or more and less than 1000 hours
×: Bonding life of less than 500 hours

The evaluation results of Examples and Comparative Examples are shown in Tables 2 to 4.

### [Table 2]

**(Table 2)**

| | No. | Wire diameter | Thickness of coating layer | Average value X^{*1} | Measurement point whose absolute deviation is 0.3X or less*² | Difference between maximum value and minimum value of approximate straight line of C_{Pt} or Cₙᵢ | Au concentration at surface | First additive element (B, P, Mg) | Second additive element (Se, Te, As, Sb) | Third additive element (Ga, Ge) | Fourth additive element (Ti, V, Cr, Mn, Fe, Co, Zn, Zr, Nb, Mo, Ru, Rh, Ag, In, Sn, Ta, W, Os, Ir, Pd, Au, Bi) | FAB shape | High-temperature and High-humidity reliability of 1st bonding part | Compression -bonding shape | Bondability of 2nd bonding part | High-temperature reliability of 1st bonding part | Wire-drawing processa bility |
|---|---|---|---|---|---|---|---|---|---|---|---|---|---|---|---|---|---|
| | | um | nm | | % | atomic% | atomic% | ppm by mass | ppm by mass | % by mass | ppm by mass mass | | | | | | |
| | 1 | 18 | 94 | 11.5 | 63 | 19 | | | | | | ⊚ | ○ | ○ | ○ | ○ | ○ |
| | 2 | 18 | 56 | 20.0 | 83 | 17 | | | | | | ⊚ | ○ | ○ | ○ | ○ | ○ |
| | 3 | 18 | 109 | 30 | 58 | 14 | 20 | | | | | ⊚ | ○ | ○ | ⊚ | ○ | ○ |
| | 4 | 18 | 125 | 6.1 | 93 | 27 | | | | | | ○ | ○ | ○ | ○ | ○ | ○ |
| | 5 | 18 | 56 | 10.1 | 50 | 6 | | | | | | ⊚ | ○ | ○ | ○ | ○ | ○ |
| | 6 | 18 | 106 | 0.3 | 99 | 14 | | | | | | ⊚ | ⊚ | ○ | ○ | ○ | ○ |
| | 7 | 18 | 44 | 30 | 84 | 21 | 35 | | | | | ○ | ○ | ○ | ⊚ | ○ | ○ |
| | 8 | 18 | 67 | 11.5 | 56 | 24 | 10 | | | | | ○ | ○ | ○ | ⊚ | ○ | ○ |
| | 9 | 18 | 21 | 157 | 61 | 17 | | | | | | ⊚ | ○ | ○ | ○ | ○ | ○ |
| | 10 | 18 | 90 | 2.0 | 82 | 27 | | | | | | ○ | ⊚ | ○ | ○ | ○ | ○ |
| | 11 | 18 | 61 | 19.0 | 76 | 23 | | | | | | ○ | ○ | ○ | ○ | ○ | ○ |
| Example | 12 | 18 | 130 | 5.3 | 76 | 27 | | | | | | ○ | ○ | ○ | ○ | ○ | ○ |
| | 13 | 18 | 87 | 3.0 | 63 | 26 | | | | | | ○ | ○ | ○ | ○ | ○ | ○ |
| | 14 | 18 | 10 | 7.3 | 53 | 16 | | | | | | ⊚ | ○ | ○ | ○ | ○ | ○ |
| | 15 | 18 | 72 | 15.7 | 74 | 20 | 90 | B:1 | | | | ⊚ | ○ | ⊚ | ⊚ | ○ | ○ |
| | 16 | 18 | 110 | 2.0 | 73 | 17 | 65 | P:52 | | | | ⊚ | ○ | ⊚ | ○ | ○ | ○ |
| | 17 | 18 | 29 | 13.3 | 65 | 24 | | B:55,Mg:45 | | | | ○ | ⊚ | ⊚ | ⊚ | ○ | ○ |
| | 18 | 18 | 47 | 11.5 | 73 | 10 | | | Se:82 | | | ○ | ⊚ | ○ | ○ | ○ | ○ |
| | 19 | 18 | 122 | 13.3 | 72 | 5 | | | Te:12 | | | ⊚ | ⊚ | ○ | ○ | ○ | ○ |
| | 20 | 18 | 120 | 7.3 | 78 | 11 | | | As:1 | | | ⊚ | ⊚ | ○ | ○ | ○ | ○ |
| | 21 | 18 | 54 | 10.1 | 84 | 6 | | | Se:33,Sb:34 | | | ⊚ | ⊚ | ○ | ○ | ○ | ○ |
| | 22 | 18 | 51 | 5.3 | 96 | 21 | | | | Ge:0.011 | | ○ | ○ | ○ | ○ | ⊚ | ○ |
| | 23 | 18 | 49 | 2.0 | 98 | 26 | | | | Ga0.38 | | ○ | ○ | ○ | ○ | ⊚ | ○ |
| | 24 | 18 | 12 | 5.3 | 69 | 9 | | | | Ga:0.75,Ge:0.75 | | ⊚ | ○ | ○ | ○ | ⊚ | ○ |

| | | | | | | | | | | | | | | | | | |
|---|---|---|---|---|---|---|---|---|---|---|---|---|---|---|---|---|---|
| *¹ Average value X of ratio C_{Pt}/C_{Ni} of Pt concentration C_{Pt} (atomic%) to Ni concentration C_{Ni} (atomic%) for all measurement points in coating layer *² Proportion (%) of total number of measurement points in coating layer whose absolute deviation from average value X is 0.3X or less relative to total number of measurement points in coating layer | | | | | | | | | | | | | | | | | |

### [Table 3]

**(Table 3)**

| | No. | Wire diameter | Thickness of coating layer | Average value X*¹ | Measurement point whose absolute deviation is 0.3X or less*² | Difference between maximum value and minimum value of approximate straight line of C_{Pt} or Cₙᵢ | Au concentration at surface | First additive element (B, P, Mg) | Second additive element (Se, Te, As, Sb) | Third additive element (Ga, Ge) | Fourth additive element (Ti, V, Cr, Mn, Fe, Co, Zn, Zr, Nb, Mo, Ru, Rh, Ag, In, Sn, W, Ir, Pd, Au, Bi) | FAB shape | High-temperature and High-humidity reliability of 1st bonding part | Compression -bonding shape | Bondability of 2nd bonding part | High-temperature reliability of 1st bonding part | Wire-drawing processa bility |
|---|---|---|---|---|---|---|---|---|---|---|---|---|---|---|---|---|---|
| | | | nm | | % | atomic% | atomic% | ppm by mass | ppm by mass | % by mass | ppm by mass | | | | | | |
| | 25 | 18 | 80 | 1.0 | 75 | 18 | | | | | Os, | ⊚ | ⊚ | ○ | ○ | ○ | ⊚ |
| | 26 | 18 | 44 | 2.6 | 54 | 10 | | | | | V20,Bi:125 | ⊚ | ○ | ○ | ○ | ○ | ⊚ |
| | 27 | 18 | 116 | 2.7 | 62 | 8 | | | | | Cr:344 | ⊚ | ⊚ | ○ | ○ | ○ | ⊚ |
| | 28 | 18 | 19 | 6.1 | 76 | 7 | | | | | Mn:9,Pd:24,Ir:33 | ⊚ | ○ | ○ | ○ | ○ | ⊚ |
| | 29 | 18 | 88 | 1.0 | 70 | 11 | | | | | Fe:450 | ⊚ | ⊚ | ○ | ○ | ○ | ⊚ |
| | 30 | 18 | 21 | 0.4 | 73 | 9 | | | | | Co:333.ln:98 | ⊚ | ○ | ○ | ○ | ○ | ⊚ |
| | 31 | 18 | 65 | 05 | 66 | 11 | | | | | Zr:13,Os:213 | ⊚ | ⊚ | ○ | ○ | ○ | ⊚ |
| | 32 | 18 | 26 | 2.3 | 74 | 9 | | | | | Ta, Nb:44,W:22,Mo:84 | ⊚ | ○ | ○ | ○ | ○ | ⊚ |
| | 33 | 18 | 37 | 26 | 79 | 11 | | | | | Ru:4,Ta:3 | ⊚ | ○ | ○ | ○ | ○ | ⊚ |
| | 34 | 18 | 91 | 2.8 | 79 | 19 | | | | | Rh:77,Ag:38,In:57 | ⊚ | ⊚ | ○ | ○ | ○ | ⊚ |
| | 35 | 18 | 105 | 32 | 84 | 13 | | | | | Sn:345 | ⊚ | ○ | ○ | ○ | ○ | ⊚ |
| Example | 36 | 18 | 90 | 4.0 | 84 | 23 | | | | | Ti:5 Au:11 | ○ | ○ | ○ | ○ | ○ | ⊚ |
| | 37 | 18 | 45 | 1.0 | 72 | 20 | | | | | Ag:6 | ⊚ | ○ | ○ | ○ | ○ | ⊚ |
| | 38 | 18 | 15 | 4.6 | 76 | 21 | | Mg:24 | As:50 | | | ○ | ○ | ⊚ | ○ | ○ | ○ |
| | 39 | 18 | 32 | 2.7 | 77 | 4 | | B:95 | | Ga:0.005.Ge:0.007 | | ⊚ | ⊚ ○ | ⊚ | ○ | ⊚ | ○ |
| | 40 | 18 | 36 | 2.1 | 79 | 17 | | P:23,Mg:38 | | | Fe:34 | ⊚ | ○ | ⊚ | ○ | ○ | ⊚ |
| | 41 | 18 | 38 | 1.3 | 85 | 16 | | | Sb:100 | Ge:0.03 | | ⊚ | ⊚ | ○ | ○ | ⊚ | ○ |
| | 42 | 18 | 21 | 1.5 | 58 | 14 | | | Se:21 | | Rh:61 | ⊚ | ⊚ | ○ | ○ | ○ | ⊚ |
| | 43 | 18 | 107 | 1.9 | 69 | 4 | | | | Ge:1.2 | Mo:6 | ⊚ | ⊚ | ○ | ○ | ⊚ | ⊚ |
| | 44 | 18 | 56 | 3.2 | 71 | 11 | | B:42 | As:22 | Ga:0.8 | | ⊚ | ⊚ | ⊚ | ○ | ⊚ | ○ |
| | 45 | 18 | 19 | 35 | 96 | 14 | | P:8, Mg:31 | Te:38 | | Zn:300,Zr:33 | ⊚ | ⊚ | ⊚ | ○ | ○ | ⊚ |
| | 46 | 18 | 21 | 3.8 | 59 | 22 | | | As:3,Sb:5 | Ge:0.03 | Co:123 | ○ | ⊚ | ○ | ○ | ⊚ | ⊚ |
| | 47 | 18 | 53 | 32 | 67 | 19 | 85 | P:55 | Te:11 | Ga:0.42 | Ag:15 | ⊚ | ⊚ | ⊚ | ⊚ | ⊚ | ⊚ |
| | 48 | 18 | 64 | 5.7 | 66 | 11 | 78 | B:5,P45 | Se:12.Te:6 | Ga:0.56 | Au:87 | ⊚ | ⊚ | ⊚ | ⊚ | ⊚ | ⊚ |

| | | | | | | | | | | | | | | | | | |
|---|---|---|---|---|---|---|---|---|---|---|---|---|---|---|---|---|---|
| *¹ Average value X of ratio C_{Pt}/C_{Ni} of Pt concentration C_{Pt} (atomic%) to Ni concentration C_{Ni} (atomic%) for all measurement points in coating layer *² Proportion (%) of total number of measurement points in coating layer whose absolute deviation from average value X is 0.3X or less relative to total number of measurement points in coating layer | | | | | | | | | | | | | | | | | |

### [Table 4]

**(Table 4)**

| | No. | Wire diameter | Thickness of coating layer | Average value X*¹ | Measurement point whose absolute deviation is 0.3X or less*² | Difference between maximum value and minimum value of approximate straight line of C_{Pt} or Cₙᵢ | Au concentration at surface | First additive element (B, P, Mg) | Second additive element (Se, Te, As, Sb) | Third additive element (Ga, Ge) | Fourth additive element (Ti, V, Cr, Mn, Fe, Co, Zn, Zr, Nb. Mo, Ru, Rh, Ag, In, Sn, Ta, W, Os, Ir, Pd, Au, Bi) | FAB shape | High-temperature and High-humidity reliability of 1st bonding part | Compression -bonding shape | Bondability of 2nd bonding part | High-temperature reliability of 1st bonding part | Wire-drawing processaa bility |
|---|---|---|---|---|---|---|---|---|---|---|---|---|---|---|---|---|---|
| | | um | nm | | % | atomic% | atomic% | oom by mass | ppm by mass | % bv mass | ppm by mass | | | | | | |
| | 1 | 18 | 7 | 22 | 55 | 22 | | | | | | ○ | × | ○ | ○ | × | ○ |
| Comparative Example | 2 | 18 | 135 | 11.5 | 78 | 18 | | | | | | × | | × | ○ | Q | ○ |
| | 3 4 | 18 | 56 | 0.2 | 82 | 15 | | | | | | Q | ○ × | Q | ○ | ○ | ○ |
| | | 18 | 42 | 24.0 | 72 | 23 | | | | | | Q | × | ○ | ○ | ○ | ○ |
| | 5 | 18 | 63 | 3.8 | 48 | 13 | | | | | | × | ○ | × | ○ | ○ | ○ |

| | | | | | | | | | | | | | | | | | |
|---|---|---|---|---|---|---|---|---|---|---|---|---|---|---|---|---|---|
| *¹ Average value X of ratio C_{Pt}/C_{Ni} of Pt concentration C_{Pt} (atomic%)to Ni concentration C_{Ni} (atomic%) for all measurement points in coating layer *² Proportion (%) of total number of measurement points in coating layer whose absolute deviation from average value X is 0.3X or less relative to total number of measurement points in coating layer | | | | | | | | | | | | | | | | | |

It was confirmed that all wires of Examples Nos. 1 to 48 each included the coating layer satisfying all of the conditions (1) to (3) specified in this specification, provided a favorable FAB shape, and provided favorable high-temperature and high-humidity reliability of the 1st bonding part even in a case of performing post-curing associated with sealing at a low temperature and for a short time. The wires of Example Nos. 6, 16, 18 to 21, 25, 27, 29, 31, 34, 41 to 45, 47, and 48 achieved an especially excellent FAB shape and high-temperature and high-humidity reliability of the 1st bonding part. It was confirmed that, at least for the wires in these Examples, when defining the average value of C_{Pt} (atomic%) for all measurement points in the coating layer as X_{Pt}, the total number of measurement points in the coating layer whose absolute deviation from the average value X_{Pt} was 0.1X_{Pt} or less was 50% or more relative to the total number of measurement points in the coating layer, and when defining the average value of C_{Ni} (atomic%) for all measurement points in the coating layer as X_{Ni}, the total number of measurement points in the coating layer whose absolute deviation from the average value X_{Ni} was 0.1X_{Ni} or less was 50% or more relative to the total number of measurement points in the coating layer.

Furthermore, it was confirmed that the wires of Example Nos. 3, 7, 8, 15, 16, 47, and 48 containing Au at the surface thereof exhibited a particularly excellent bondability of the 2nd bonding part.

Furthermore, it was confirmed that the wires of Example Nos. 15 to 17, 38 to 40, 44, 45, 47, and 48 containing the first additive element of 1 ppm by mass or more in total achieved an especially excellent compression-bonding shape of the 1st bonding part. It was confirmed that the wires of Example Nos. 18 to 21, 38, 41, 42, and 44 to 48 containing the second additive element of 1 ppm by mass or more in total achieved an especially excellent bond reliability of the 1st bonding part in a high-temperature and high-humidity environment. It was confirmed that the wires of Example Nos. 22 to 24, 39, 41, 43, 44, and 46 to 48 containing the third additive element of 0.011% by mass or more in total achieved an especially excellent bond reliability of the 1st bonding part in a high-temperature environment. It was confirmed that the wires of Example Nos. 25 to 37, 40, 42, 43, and 45 to 48 containing the fourth additive element of 5 ppm by mass or more in total were especially excellent in wire-drawing processability.

On the other hand, the wires of Comparative Example Nos. 1 to 5 included the coating layer that did not satisfy at least one of the conditions (1) to (3) specified in this specification, and it was confirmed that they were poor in any one of the FAB shape and the high-temperature and high-humidity reliability of the 1st bonding part.

### Reference Signs List

- 1: bonding wire (wire)
- 2: measuring surface
- X: center of width of wire
- W: width of wire (wire diameter)
- wₐ: width of measuring surface
- lₐ: length of measuring surface

## Claims

1. A bonding wire comprising: a core material of Cu or Cu alloy; and a coating layer having a total concentration of Pt and Ni of 90 atomic% or more formed on a surface of the core material, wherein
in a concentration profile in a depth direction of the wire obtained by performing measurement using Auger electron spectroscopy (AES) so that the number of measurement points in the depth direction is 50 or more for the coating layer,
a thickness of the coating layer is 10 nm or more and 130 nm or less,
an average value X is 0.3 or more and 20.0 or less where X is defined as an average value of a ratio of an Ni concentration C_{Ni} (atomic%) to a Pt concentration C_{Pt} (atomic%), C_{Pt}/C_{Ni}, for all measurement points in the coating layer, and
a total number of measurement points in the coating layer whose absolute deviation from the average value X is 0.3X or less is 50% or more relative to a total number of measurement points in the coating layer.

2. The bonding wire according to claim 1, wherein when linearly approximating C_{Pt} or C_{Ni} by the method of least squares for all measurement points in the coating layer, a difference between a maximum value and a minimum value of the obtained approximate straight line in a depth range of the coating layer is 20 atomic% or less.

3. The bonding wire according to claim 1 or 2, wherein the concentration profile in the depth direction of the wire is obtained by performing measurement using AES under the following <Condition> while digging down the wire from its surface in the depth direction by Ar sputtering:
<Condition> a center of width of a measuring surface is aligned with a center of width of the wire, the width of the measuring surface is 5% or more and 15% or less of a diameter of the wire, and a length of the measuring surface is five times the width of the measuring surface.

4. The bonding wire according to any one of claims 1 to 3, wherein the bonding wire contains Au at a surface thereof.

5. The bonding wire according to claim 4, wherein a concentration of Au at the surface of the wire is 10 atomic% or more and 90 atomic% or less.

6. The bonding wire according to claim 5, wherein the concentration of Au at the surface of the wire is measured using AES under the following <Condition>:
<Condition> a center of width of a measuring surface is aligned with a center of width of the wire, the width of the measuring surface is 5% or more and 15% or less of a diameter of the wire, and a length of the measuring surface is five times the width of the measuring surface.

7. The bonding wire according to any one of claims 1 to 6, wherein the bonding wire contains one or more elements selected from the group consisting of B, P and Mg (hereinafter referred to as a "first additive element"), and a total concentration of the first additive element is 1 ppm by mass or more and 100 ppm by mass or less relative to the entire wire.

8. The bonding wire according to any one of claims 1 to 7, wherein the bonding wire contains one or more elements selected from the group consisting of Se, Te, As and Sb (hereinafter referred to as a "second additive element"), and a total concentration of the second additive element is 1 ppm by mass or more and 100 ppm by mass or less relative to the entire wire.

9. The bonding wire according to any one of claims 1 to 8, wherein the bonding wire contains one or more elements selected from the group consisting of Ga and Ge (hereinafter referred to as a "third additive element"), and a total concentration of the third additive element is 0.011% by mass or more and 1.5% by mass or less relative to the entire wire.

10. The bonding wire according to any one of claims 1 to 3 and 7 to 9, wherein the bonding wire contains one or more elements selected from the group consisting of Ti, V, Cr, Mn, Fe, Co, Zn, Zr, Nb, Mo, Ru, Rh, Ag, In, Sn, Ta, W, Os, Ir, Pd, Au, and Bi (hereinafter referred to as a "fourth additive element"), and a total concentration of the fourth additive element is 5 ppm by mass or more and 450 ppm by mass or less relative to the entire wire.

11. The bonding wire according to any one of claims 4 to 6, wherein the bonding wire contains one or more elements selected from the group consisting of Ti, V, Cr, Mn, Fe, Co, Zn, Zr, Nb, Mo, Ru, Rh, Ag, In, Sn, Ta, W, Os, Ir, Pd, Au, and Bi (hereinafter referred to as a "fourth additive element"), and a total concentration of the fourth additive element (provided that a concentration of Au is a concentration in the core material portion) is 5 ppm by mass or more and 450 ppm by mass or less relative to the entire wire.
